# EUROPEAN PATENT APPLICATION

(11) **EP 3 048 643 A1**
(43) Date of publication of application: **27.07.2016**
(21) Application number: 15305072.9
(22) Date of filing: 23.01.2015
(51) Int. Cl.: H01L 23/34, H01L 23/473, F28F 13/00

(54) **Device and method**

(71) Applicant: ALCATEL LUCENT, 92100 Boulogne-Billancourt (FR)
(72) Inventor: Lei, Shenghui, DUBLIN, 15 (IE)
(74) Representative: Coghlan, Judith Elizabeth Kensy

(57) **Abstract**

Aspects and embodiments provide a device and method. One aspect provides a device comprising: a first thermally conductive element and a second thermally conductive element separated from the first thermally conductive element by a thermal gate. The thermal gate is arranged to be thermally coupled to the first and second thermally conductive elements. The thermal gate is configured to be switched between: a first state in which the gate is thermally conductive at a first thermal conduction rate between said first and second thermally conductive elements; and a second state in which the gate is thermally conductive at a second thermal conduction rate between the first and second thermally conductive elements, and wherein the first thermal conduction rate is higher than the second thermal conduction rate. The arrangement may allow for intelligent modulation of heat flux between a heat source and drain.

## Description

### FIELD OF THE INVENTION

A device and method.

### BACKGROUND

Thermal management of small scale integrated devices can be a barrier to enabling a large increase in manageable data traffic. For example, in photonic integrated circuits (PICs) and opto-electronic integrated circuits (ICs) there are integrated devices whose large heat flux levels require management. Some integrated devices and components included on an integrated circuit may be highly temperature sensitive and, as a result, the temperature of those devices may need to be actively managed or controlled. For some devices that temperature control must be performed within tight limits; for example, within a tolerance of 0.1°C. Temperature control may be necessary on an individual and independent component basis, or across various components or regions of an integrated circuit.

In the case of some integrated circuits, it may be beneficial to provide integrated thermal management solutions. Advanced thermal management concepts have a role to play in reducing energy consumption in photonics and other integrated circuits.

It is desired to provide devices and methods to allow for thermal management of components.

### SUMMARY

Accordingly, a first aspect provides: a device comprising: a first thermally conductive element; a second thermally conductive element separated from the first thermally conductive element by a thermal gate, that thermal gate being arranged to be thermally coupled to the first and second thermally conductive elements; wherein the thermal gate is configured to be switched between:
a first state in which the gate is thermally conductive at a first thermal conduction rate between the first and second thermally conductive elements; and a second state in which the gate is thermally conductive at a second thermal conduction rate between the first and second thermally conductive elements, wherein the first thermal conduction rate is higher than the second thermal conduction rate.

The first aspect recognizes that an electronic transistor is a component which allows a relatively small signal applied between one pair of terminals to be used to control a larger signal. Described arrangements recognize that it is possible to provide a device which acts as a thermal transistor. That is to say, in relation to heat flow, a device which enables the switching, amplification and/or modulation of heat flux which can enable micro-scale or nano-scale thermal management.

The first aspect provides a device which includes thermally conductive elements or members along which heat flux may pass in accordance with a temperature gradient across those thermally conductive elements. The device includes a thermal gate, which can be switched between two states. Those states may, in general, allow the gate to act as a thermally insulating "break" or gap in the device between the thermally conductive elements thus preventing heat flow between them, or a thermal conductor, allowing heat flow through the thermal gate between the thermally conductive elements.

The thermal management device of the first aspect may comprise a first thermally conductive element; a second thermally conductive element configured to be separated from the first thermally conductive element. Accordingly, heat may flow between the first and second elements or members by means of thermal conduction along a temperature gradient.

The first and second elements may be separated by a thermal gate. The thermal gate may be arranged to be thermally coupled to the first and second thermally conductive elements. Accordingly, heat flow between the elements may be controlled by the thermal properties of the gate.

The thermal gate maybe configured to be switched between a first state in which said gate is thermally conductive at a first thermal conduction rate between said first and second thermally conductive elements; and a second state in which said gate is thermally conductive at a second thermal conduction rate between said first and second thermally conductive elements, wherein the first thermal conduction rate is higher than the second thermal conduction rate. The first thermal conduction rate may provide high conductivity and the second thermal conduction rate may substantially provide thermal insulation. In some arrangements, the thermal gate may be switchable between: a first state in which the gate is thermally conductive and heat can flow between the first and second thermally conductive elements; and a second state in which the gate is thermally insulating and heat flow between the first and second thermally conductive elements is inhibited. Accordingly, by controlling the thermal properties of the gate, a flow of heat across the device may be controlled. By way of example, it may be considered that a typical "thermally conducting" material might have a thermal conductivity of more than 10W/m-K, whilst a typical "thermally insulating" material might have a thermal conductivity of less than 0.08W/m-K.

The thermal device of the first aspect may comprise a microfluidic thermal management device. Such a device may be integrated into a circuit or larger device. The thermal device of the first aspect may comprise a component in a heat flow system provided in relation to heat management control of one or more electronic or optoelectronic components.

In one embodiment, the thermal gate comprises: a channel configured to receive a fluid, and wherein the switching between the first and second states comprises changing a fluid deployment within the channel. Accordingly, the channel may comprise a part of microfluidic circuit. The thermal gate may comprise a channel, void, or other structure suitable to receiving a fluid. The thermal gate may be dimensioned to ensure substantial thermal isolation between the first and second thermally conductive elements when in the second state, in which thermal conduction between the first and second elements is substantially prevented. In such a state, the thermal gate is a thermal insulator arranged to thermally insulate the first element from the second and vice versa. It will be understood that changing a fluid deployment may include changing the fluid material, for example, exchanging one fluid for another fluid and/or changing the manner in which a fluid is employed inside the thermal gate, for example, switching from a fluid with bubbles to one without bubbles. Furthermore, changing fluid deployment may include: changing from one fluid to a different fluid, using two fluid, each having a different thermal conductivity to the other, changing the volume of fluid in the channel or speed of flow of a fluid within the channel and similar changes to deployment.

In one embodiment, the device comprises: a fluid flow controller configured to change the fluid deployment within the channel. Switching between the first and second states may be effected by an appropriate microfluidic fluid flow controller. That controller may act to control the flow of any fluid through the thermal gate. It may be operable to change a fluid from a first to a second fluid, to change the arrangement of the fluid in the thermal gate, to hold fluid in the thermal gate or ensure a continuous flow of fluid through the thermal gate, as appropriate, to manage heat flow between the first and second elements.

In one embodiment, the fluid flow controller is configured to switch between the first and second state by changing the fluid within the channel from a first fluid arrangement in the channel to a second fluid arrangement. In one embodiment, at least one fluid arrangement comprises: substantially filling the thermal gate channel with a fluid. In one embodiment, at least one fluid arrangement comprises: maintaining a static volume of fluid within the channel. In one embodiment, at least one fluid arrangement comprises: a flow of fluid within the channel.

In one embodiment, at least one fluid arrangement in the thermal gate channel comprises: a plurality of thermally insulating elements surrounded by a fluid. In one embodiment, the thermally insulating elements comprise bubbles formed in or by a liquid or fluid within the thermal gate. In one embodiment, the device further comprises a device for creation of bubbles within a fluid within the thermal gate.

In one embodiment, the device comprises: a coating between at least one of the first and second thermally conductive elements and the thermal gate, the coating being configured to inhibit thermal radiation from the at least one of the first and second thermally conductive elements and the thermal gate. In one embodiment, the device comprises: a coating between the first thermally conductive element and the thermal gate and between the thermal gate and the second thermally conductive element, the coating being configured to inhibit heat transfer by radiation between the first and second thermally conductive elements. Accordingly, heat transfer across the gate by means other than conduction can be reduced, restricted or prevented. Control of heat flow between the elements can then be controlled by appropriate control of the thermal conduction properties of the thermal gate.

In one embodiment, one of the first and second thermally conductive elements is configured to be in thermal contact with a heat source. In one embodiment, one of the first and second thermally conductive elements is configured to be in thermal contact with a heat sink. Accordingly, heat can be transferred to and from a source or sink by appropriate deployment of the thermal management device of the first aspect.

In alternative embodiments, one of the thermally conductive elements may itself comprise a heat source. In alternative embodiments, one of the thermally conductive elements may itself comprise a heat sink. Accordingly, some embodiments may provide a thermal gate directly adjacent to a heat source or heat sink. Accordingly, thermal management of a component may be more immediately responsive to the configuration of the thermal gate.

A second aspect provides a method comprising: providing a first thermally conductive element; providing a second thermally conductive element separated from the first thermally conductive element by a thermal gate, the thermal gate being thermally coupled to the first and second thermally conductive elements; and switching the thermal gate between: a first state in which the gate is thermally conductive at a first thermal conduction rate between the first and second thermally conductive elements; and a second state in which the gate is thermally conductive at a second thermal conduction rate between the first and second thermally conductive elements, wherein the first thermal conduction rate is higher than the second thermal conduction rate.

In one embodiment, the thermal gate comprises: a channel configured to receive a fluid, and wherein the switching between the first and second states comprises changing a fluid deployment within the channel.

In one embodiment, the method comprises: providing a fluid flow controller and configuring that fluid flow controller to change the fluid within the channel.

In one embodiment, the fluid flow controller is configured to switch between the first and second state by changing the fluid within the channel from a first fluid arrangement in the channel to a second fluid arrangement.

In one embodiment, at least one fluid arrangement in the thermal gate channel comprises: a plurality of thermally insulating elements surrounded by a fluid.

In one embodiment, at least one fluid arrangement comprises: substantially filling the thermal gate channel with a fluid.

In one embodiment, at least one fluid arrangement comprises: maintaining a static volume of fluid within the channel.

In one embodiment, at least one fluid arrangement comprises: a flow of fluid within the channel.

In one embodiment, the method comprises: providing a coating between at least one of the first and second thermally conductive elements and the thermal gate, the coating being configured to inhibit thermal radiation from the at least one of the first and second thermally conductive elements and the thermal gate.

In one embodiment, the method comprises: providing a coating between the first thermally conductive element and the thermal gate and between the thermal gate and the second thermally conductive element, the coating being configured to inhibit heat transfer by radiation between the first and second thermally conductive elements.

In one embodiment, the method comprises: configuring one of the first and second thermally conductive elements to be in thermal contact with a heat source.

In one embodiment, the method comprises: configuring one of the first and second thermally conductive elements to be in thermal contact with a heat sink.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

### BRIEF DESCRIPTION OF THE DRAWINGS

Embodiments of the present invention will now be described further, with reference to the accompanying drawings, in which:

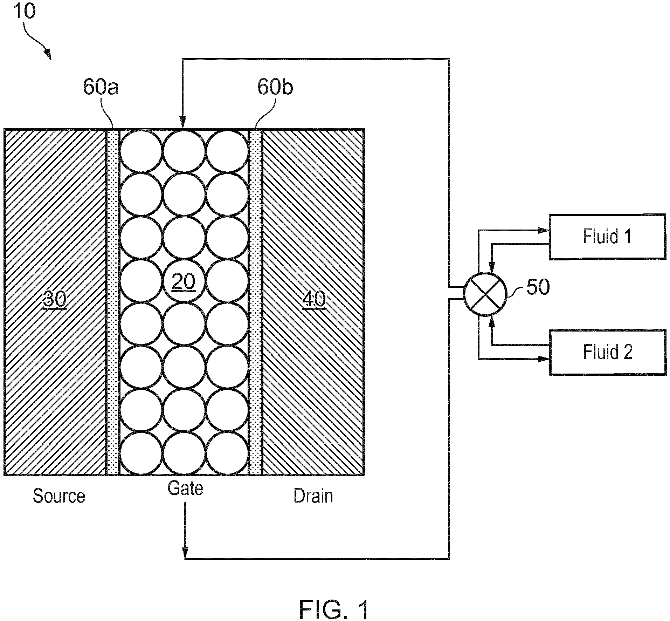

Figure 1 illustrates schematically main components of a thermal management device according to one arrangement.

### DESCRIPTION OF THE EMBODIMENTS

It will be appreciated that an electronic transistor is a component which allows a relatively small signal applied between one pair of terminals to be used to control a larger signal. Described arrangements recognize that it is possible to provide a device which acts as a thermal transistor. That is to say, in relation to heat flow, a device which enables the switching, amplification and/or modulation of heat flux which enables micro-scale or nano-scale thermal management.

Some described arrangements provide a thermal transistor device which is configured such that small change in thermal properties to a region of a device can be used to control heat flux across the device. One arrangement provides a thermal gate, configured such that a microfluidic flow can be employed to modulate heat flux between a heat source and a heat drain or heat sink.

Arrangements may enable intelligent control of an operating temperature of an electronic or optoelectronic device. Such devices may be stand alone, or may be provided on an integrated circuit, silicon wafer or form part of a larger device. Heat generated by components in such arrangements may be controlled by thermal management device arrangements described herein, allowing heat flow around or within a device to take a route which dissipates that heat along a chosen path. Provision of a thermal transistor makes such thermal control a possibility. For example, thermal crosstalk can cause thermal management issues in such devices. Described arrangements can provide a thermal transistor which can be configured such that heat flux away from a heat generating component is "turned off" thus allowing for thermal isolation of each heat generating component from other components. That thermal isolation may be switched on during operation of the heat generating component if it is determined the heat generated by that component is detrimental to one or more other components.

Provision of a thermal transistor in accordance with described arrangements may provide an alternative to mechanisms to address thermal crosstalk, such as employing an isolating thermal insulation layer configured to isolate each device. Such a one-way "solution" does not allow for thermal management approach which can operate to deliberately dissipate heat towards neighbouring devices, thus allowing the combined devices to behave as a thermal spreader, if necessary.

In relation to semiconductor laser devices, it will be appreciated that a great amount of heat generated may "flow back" to an active semiconductor laser region. That flow back can significantly increase thermal load being dissipated. Arrangements described may provide a thermal transistor which can be used as a barrier to inhibit that heat flow back. Typical semiconductor laser device cooling techniques operate to dump both generated heat together with any thermal flow-back to a common heat sink. Before discussing the embodiments in any more detail, first an overview will be provided.

Arrangements generally provide a thermal management device. Such a device comprises: a first thermally conductive element and a second thermally conductive element. Those elements are configured such that the second element is separated from the first thermally conductive element by a thermal gate. The thermal gate is arranged to be thermally coupled to the first and second thermally conductive elements. The thermal gate is configured to be switched between a first state and a second state. When in the first state, the gate conducts heat at a first rate, and when in the second state, the gate conducts heat at a second rate. The first thermal heat conduction transfer rate is higher than the second. In other words, some arrangements may provide that when in the first state, the gate is thermally conductive and heat can flow between the first and second thermally conductive elements. When in the second state, the gate is thermally insulating and any heat flow between the first and second thermally conductive elements is inhibited or prevented.

Figure 1 illustrates schematically main components of a device 10 according to one arrangement. The principle of operation of such a device is such that a thermal gate 20 is created in a heat flux path between a heat source 30 capable of generating heat and a heat drain, for example, a heat sink, capable of absorbing and dissipating heat.

In one arrangement, the thermal gate 20 comprises: a channel or other similar void configured to receive a fluid. In some arrangements the switching between the first and second states may be effected by changing a fluid within said channel or other similar void.

In some arrangements the device may comprise a fluid flow controller 50. That fluid flow controller may be configured to change a fluid within a thermal gate. The fluid flow controller maybe controlled such that it operates to switch between the first and second state by changing the fluid within the thermal gate from a first fluid arrangement in the thermal gate channel or void to a second fluid arrangement. The fluid arrangement may, for example, be altered from one in which the void is empty, to one in which the void is filled with fluid. One fluid arrangement may comprise: a plurality of thermally insulating elements surrounded by a fluid. One of the fluid arrangement may, for example, comprise one in which the fluid includes thermally insulating voids, or other similar additives. The voids may, for example, comprise bubbles formed in the fluid. One fluid arrangement may comprise: substantially filling the thermal gate with a fluid. One fluid arrangement may comprise: a static volume of fluid within the thermal gate. One fluid arrangement may comprise: a flow of fluid through the thermal gate 20.

In the arrangement shown schematically in Figure 1, the thermal management device comprises a coating 60a, 60b between each of the first and second thermally conductive elements 30,40 and the thermal gate 20. That coating 60a, 60b is configured to inhibit thermal radiation from either side of the thermal gate to the other side of the thermal gate 20. That is to say, heat transfer between the first and second conductive elements (and vice versa) by means of thermal radiation is inhibited by the provided coating. The heat flux across the thermal gate, between the first and second conductive elements, may therefore be primarily controlled by controlling conductive properties of the thermal gate.

In use, a device such as the one shown schematically in Figure 1 can be configured to that one side of the device is in thermal contact with a heat source and the other side is in thermal contact with a heat sink. In other words, one of said first and second thermally conductive elements is in thermal contact which a heat source, the other with a heat sink, such that there is a thermal gradient across the first and second thermally conductive elements, that thermal gradient resulting in a heat flux across the first and second elements, in dependence upon the state of the thermal gate located between the first and second elements.

In the arrangement shown, the thermal gate comprises a void which can be filled with functional fluids. In the arrangement shown, an insulating fluid arrangement has been created in the thermal gate void, by means of microfluidic techniques. In this instance the microfluidic techniques have been deployed to create bubbles from a fluid. That bubble structure within the thermal gate void forms a thermally insulating layer between the two sides of the thermal management device.

In the arrangement of Figure 1, two layers (60a, 60b) are used to reduce heat transfer by radiation and thus heat exchange between the sides of the device is primarily limited to heat conduction through the thermal gate.

Specifically in the arrangement of Figure 1, two types of fluid (fluid 1, fluid 2) are selected and deployed within the thermal gate as appropriate. One of the fluids selected has a high thermal conductivity and performs as a good thermal conductor. The other selected fluid has a poor thermal conductivity and therefore behaves as a thermal insulator. A microfluidic system is employed to control the filling of the gate and the resultant heat flux across the gate between the two thermally conductive elements is correspondingly modulated. Therefore, the thermal gate 20 between the source 30 and the drain 40 can be thermally switched as 'on' or 'off' by appropriate deployment of fluid in microchannels.

The arrangement may allow for intelligent modulation of heat flux between a heat source and drain. Possible benefits of such an arrangement include: easy operation; general application; and relatively cheap fabrication.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices maybe, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Also for purposes of this description, the terms "couple," "coupling," "coupled," "connect," "connecting,", "connected", "in contact" or "contacting" refer to any manner known in the art or later developed in which energy is allowed to be transferred between two or more elements, and the interposition of one or more additional elements is contemplated, although not required. Conversely, the terms "directly coupled," "directly connected," etc., imply the absence of such additional elements.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A device comprising:
a first thermally conductive element;
a second thermally conductive element separated from said first thermally conductive element by a thermal gate, said thermal gate being arranged to be thermally coupled to said first and second thermally conductive elements;
wherein said thermal gate is configured to be switched between:
a first state in which said gate is thermally conductive at a first thermal conduction rate between said first and second thermally conductive elements; and
a second state in which said gate is thermally conductive at a second thermal conduction rate between said first and second thermally conductive elements, wherein the first thermal conduction rate is higher than the second thermal conduction rate.

2. A device according to claim 1, wherein said thermal gate comprises: a channel configured to receive a fluid, and wherein said switching between said first and second states comprises changing a fluid deployment within said channel.

3. A device according to claim 2, wherein said device comprises: a fluid flow controller configured to change said fluid deployment within said channel.

4. A device according to claim 3, wherein said fluid flow controller is configured to switch between said first and second state by changing said fluid deployment within said channel from a first fluid arrangement in said channel to a second fluid arrangement.

5. A device according to claim 4, wherein at least one said fluid arrangement in said channel comprises: a plurality of thermally insulating elements surrounded by a fluid.

6. A device according to claim 4 or claim 5, wherein at least one said fluid arrangement comprises: substantially filling said channel with a fluid.

7. A device according to any one of claims 4 to 6, wherein at least one said fluid arrangement comprises: maintaining a static volume of fluid within said channel.

8. A device according to any one of claims 4 to 7, wherein at least one said fluid arrangement comprises: a flow of fluid within said channel.

9. A device according to any preceding claim, wherein said device comprises: a coating between at least one of said first and second thermally conductive elements and said thermal gate, said coating being configured to inhibit thermal radiation from said at least one of said first and second thermally conductive elements and said thermal gate.

10. A device according to any preceding claim, wherein said device comprises: a first coating between said first thermally conductive element and said thermal gate and a second coating between said thermal gate and said second thermally conductive element, said first and second coating being configured to inhibit heat transfer by radiation between said first and second thermally conductive elements.

11. A device according to any preceding claim, wherein one of said first and second thermally conductive elements is configured to be in thermal contact with a heat source.

12. A device according to any preceding claim, wherein one of said first and second thermally conductive elements is configured to be in thermal contact with a heat sink.

13. A method comprising:
providing a first thermally conductive element;
providing a second thermally conductive element separated from said first thermally conductive element by a thermal gate,
said thermal gate being thermally coupled to said first and second thermally conductive elements; and
switching said thermal gate between:
a first state in which said gate is thermally conductive at a first thermal conduction rate between said first and second thermally conductive elements; and
a second state in which said gate is thermally conductive at a second thermal conduction rate between said first and second thermally conductive elements, wherein the first thermal conduction rate is higher than the second thermal conduction rate.
